# EUROPÄISCHE PATENTSCHRIFT

(11) **EP 0 772 046 B1**
(45) Veröffentlichungstag und Bekanntmachung des Hinweises auf die Patenterteilung: **17.04.2002**
(21) Anmeldenummer: 96116868.9
(22) Anmeldetag: 21.10.1996
(51) Int. Cl.: G01R 1/067, G01R 15/20

(54) **Magnetfeldsensor und Strom- oder Energiesensor**
Magnetic field probe and current or energy probe
Sonde de champs magnétique et sonde de courant ou d'énergie

(30) Priorität: 30.10.1995 CH 306295
(43) Veröffentlichungstag der Anmeldung: 07.05.1997
(73) Patentinhaber: SENTRON AG, 6300 Zug (CH)
(72) Erfinder: Popovic, Radivoje, 6300 Zug (CH); Racz, Robert, 6300 Zug (CH); Hresja, Jan, 6300 Zug (CH); Blanchard, Hubert, 1800 Vevey (CH)
(74) Vertreter: Falk, Urs, Dr.

(56) Entgegenhaltungen:
- EP-A- 0 233 988
- DE-B- 1 170 537

## Beschreibung

Die Erfindung betrifft einen Magnetfeldsensor der im Oberbegriff des Anspruchs 1 genannten Art.

Ein Magnetfeldsensor der im Oberbegriff der Ansprüche 1 und 3 genannten Art zur Messung der durch einen elektrischen Leiter transportierten Energie ist aus der europäischen Patentschrift EP 233 988 A bekannt. Der Magnetfeldsensor weist ein vertikales Hallelement und zwei magnetische Flusskonzentratoren auf. Die Flusskonzentratoren und ein externes Joch bilden einen magnetischen Kreis aus ferromagnetischem Material, in dessen Luftspalt sich das Hallelement befindet.
Die Flusskonzentratoren sind gegen das Hallelement hin verjüngt ausgebildet, um im Luftspalt in Bezug auf den im Leiter fliessenden Strom ein möglichst hohes Magnetfeld und damit eine hohe Empfindlichkeit zu erreichen. Die Geometrie der Flusskonzentratoren ist dahingehend optimiert, dass der magnetische Fluss ausserhalb des Luftspaltes, d.h. der Streufeldanteil, möglichst gering ist, so dass die Linearität des Magnetfeldsensors nicht durch Sättigungseffekte der Flusskonzentratoren beeinträchtigt ist. Die minimal mögliche Breite des Luftspaltes ist durch die Abmessungen des sich darin befindenden Hallelementes nach unten begrenzt.

Mit horizontalen Hallelementen ist es zwar möglich, die Abmessungen des Luftspaltes weiter zu verringern. Da jedoch die Flusskonzentratoren prinzipiell anders ausgestaltet sein müssen, um das magnetische Feld durch das Hallelement zu leiten, ist eine solche Anordnung empfindlich auf Störfelder, die in senkrechter Richtung auf das horizontale Hallelement auftreffen.

Aus der deutschen Auslegeschrift DE 11 70 537 ist ein Strommessgerät mit einem den Stromleiter umschliessenden Joch mit mindestens zwei Luftspalten und darin angeordneten Hallspannungserzeugern bekannt.

Der Erfindung liegt die Aufgabe zugrunde, einen Magnetfeldsensor für die Messung schwacher Magnetfelder vorzuschlagen, der eine hohe Genauigkeit aufweist und wenig empfindlich gegenüber Störfeldern ist.

Die genannte Aufgabe wird erfindungsgemäss gelöst durch die Merkmale der Ansprüche 1 und 3. Vorteilhafte Ausgestaltungen ergeben sich aus den abhängigen Ansprüchen.

Nachfolgend werden ausgewählte Ausführungsbeispiele der Erfindung anhand der Zeichnung näher erläutert.

Es zeigen:
- Figur 1: einen Magnetfeldsensor im Querschnitt,
- Figur 2: den Magnetfeldsensor in einer ersten Ausführung mit zwei Hallelementen in der Draufsicht,
- Figur 3: den mit zwei speziellen Hallelementen versehenen Magnetfeldsenor,
- Figur 4a, 4b: den Magnetfeldsensor in einer zweiten Ausführung mit einem einzigen Hallelement in der Draufsicht,
- Figur 5a, 5b: weitere Magnetfeldsensoren,
- Figur 6: einen Stromsensor in der Draufsicht,
- Figur 7: den Stromsensor im Querschnitt,
- Figur 8: einen weiteren Stromsensor in der Draufsicht und
- Figur 9: den weiteren Stromsensor im Querschnitt.

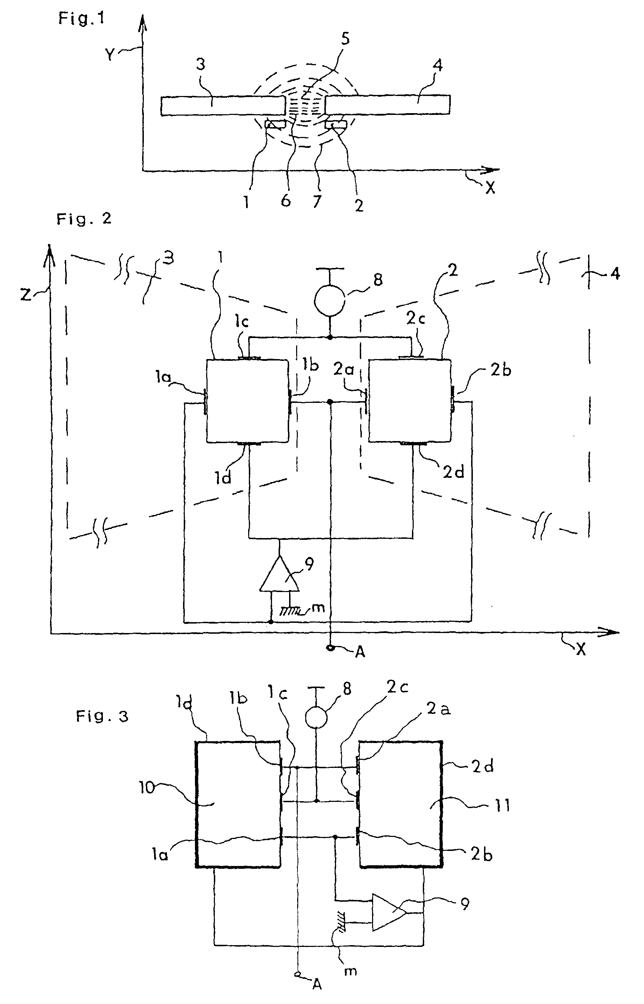

Die nicht massstabsgetreue Figur 1 zeigt in einer xy-Ebene im Querschnitt einen Magnetfeldsensor, der zwei horizontale Hallelemente 1, 2 und zwei magnetische Flusskonzentratoren 3 und 4 zur Verstärkung eines die Richtung x aufweisenden Magnetfeldes B umfasst. Die beiden Flusskonzentratoren 3 und 4 sind durch einen Luftspalt 5 getrennt. Der geometrische Verlauf der Feldlinien des Magnetfeldes B im Bereich des Luftspaltes 5 ist mit gestrichelten Linien 6, 7 dargestellt. Die zwei Hallelemente 1 und 2 sind ausserhalb des Luftspaltes 5 angeordnet. Die geometrischen Abmessungen der Flusskonzentratoren 3, 4 und ihr den Luftspalt 5 festlegender Abstand sind so gewählt, dass der Anteil der nicht direkt durch den Luftspalt 5 führenden Feldlinien 7 im Vergleich zu den durch den Luftspalt 5 führenden Feldlinien 6 möglichst gross ist. Weiter sind die geometrischen Abmessungen der Flusskonzentratoren 3, 4 so gewählt, dass Sättigungseffekte aufgrund ihrer magnetischen Eigenschaften bei einer möglichst grossen Feldstärke des Magnetfeldes B am Ort der Hallelemente 1, 2 auftreten.

Das Hallelement 1 ist von Feldlinien 7 durchflutet, die vom ersten Flusskonzentrator 3 in der Nähe des Luftspaltes 5 weggehen, das Hallelement 2 ist von den Feldlinien 7 durchflutet, die in der Nähe des Luftspaltes 5 auf den zweiten Flusskonzentrator 4 auftreffen. Bei idealer Montage durchflutet jede Feldlinie 7 entweder beide oder keines der Hallelemente 1 und 2. Da die magnetische Permeabilität der Flusskonzentratoren 3, 4 mindestens um einen Faktor 10³ grösser als die Permeabilität von Luft gewählt ist, verlassen die Feldlinien 6, 7 die Flusskonzentratoren 3, 4 unter annähernd senkrechtem Winkel. Die das Hallelement 1 durchflutenden Feldlinien 7 weisen demnach bei positiver x-Richtung des Magnetfeldes B annähernd in die negative y-Richtung (Figur 1), die das Hallelement 2 durchflutenden Feldlinien 7 in die positive y-Richtung. Somit ermöglicht diese Anordnung, dass Störfelder in y-Richtung nicht gemessen werden. Die Abmessungen der Flusskonzentratoren 3, 4 in der xz-Ebene betragen typisch einige Zehntel Millimeter, die Dicke in der xy-Ebene typisch einige 10 Mikrometer. Der Luftspalt 5 misst beispielsweise 50 Mikrometer. Diese Anordnung erlaubt, dass der Luftspalt 5 unabhängig von den Abmessungen des Hallelementes ist.

Die Figur 2 zeigt in einer zur xy-Ebene senkrechten xz-Ebene die beiden Hallelemente 1, 2 in konventioneller Ausführung mit je zwei Spannungselektroden 1a, 1b bzw. 2a, 2b und zwei Stromelektroden 1c, 1d bzw. 2c, 2d, die beiden Flusskonzentratoren 3, 4 sowie die elektrische Beschaltung der Hallelemente 1, 2. Die schematisch dargestellten Hallelemente 1, 2 sind elektrisch parallel geschaltet und von einer gemeinsamen Stromquelle 8 mit einem Strom gespeist. Mittels eines Operationsverstärkers sind die Spannungselektroden 1a bzw. 2b der Hallelemente 1, 2 virtuell an Masse m gelegt. Die beiden anderen Spannungselektroden 1b bzw. 2a der beiden Hallelemente 1, 2 sind miteinander verbunden und auf einen Ausgang A geführt, an dem die Hallspannung anliegt. Die Hallelemente 1, 2 sind so geschaltet, dass sich die individuellen Hallspannungen bei entgegengesetzter Richtung der sie durchflutenden Feldlinien 7 (Figur 1) des Magnetfeldes addieren. Die Verwendung von zwei identischen, parallel geschalteten Hallelementen 1, 2 eliminiert auch z. B. durch technologiebedingte Asymmetrien erzeugte systematische Offsetspannungen. Durch beide Hallelemente 1, 2 fliesst ein Strom l etwa gleicher Stärke und gleicher z-Richtung.

Anstelle konventioneller Hallelemente 1, 2, die eine rechteckförmige Geometrie aufweisen und bei denen auf jeder Seite des Rechtecks eine Strom- oder eine Spannungselektrode angeordnet ist, sind auch Hallelemente verwendbar, bei denen drei oder alle vier Elektroden auf einer Seite des Rechtecks angeordnet sind. Solche Hallelemente sind aus der europäischen Patentschrift EP 362 493 bekannt. Die Figur 3 zeigt einen Magnetfeldsensor und dessen elektrische Beschaltung mit zwei solchen Hallelementen 10, 11. Das besondere an diesen rechteckförmigen Hallelementen 10 und 11 ist, dass auf einer Seite des Rechtecks die drei Elektroden 1a, 1b und 1c bzw. 2a, 2b und 2c angebracht sind und dass sich die vierte Elektrode 1 bzw. 2d entlang dem gesamten Umfang der drei anderen Seiten des Rechtecks erstreckt.

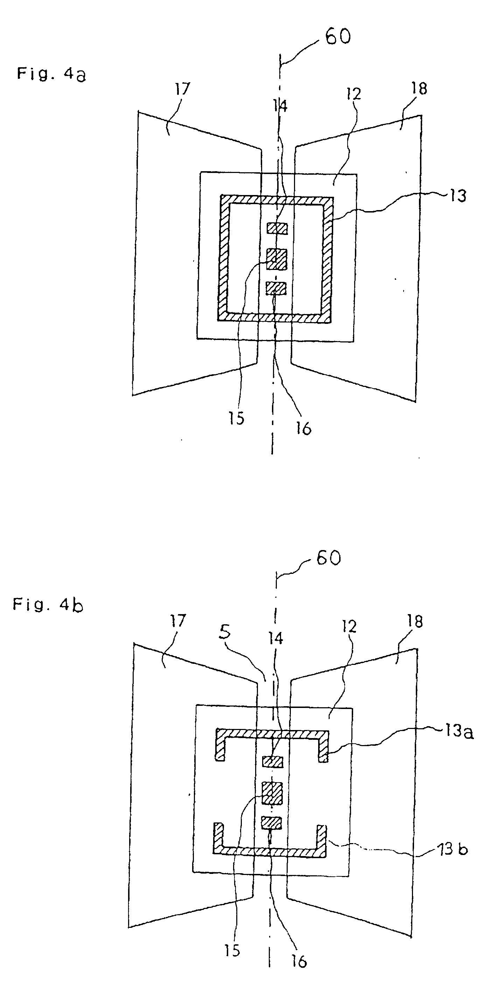

Bei einer in der Figur 4a dargestellten Weiterentwicklung sind die beiden Hallelemente 10, 11 zu einem einzigen Hallelement 12 verschmolzen, wobei die beiden ursprünglichen vierten Elektroden 1d und 2d eine einzige ringförmige Aussenelektrode 13 bilden und die jeweils gegenüberliegenden Elektroden 1b und 2a, 1c und 2c sowie 1a und 2b als innere Elektroden 14, 15 und 16 zusammenfallen. Die Elektroden 13 und 15 dienen als Stromelektroden, die Elektroden 14 und 16 als Spannungselektroden. Das Hallelement 12 lässt sich z.B. in CMOS Technologie als n-Wanne in einem p-dotierten Subsrat realisieren. Mit einer einzigen Maske lassen sich die Elektroden 13 bis 16 als stark dotierte n⁺⁺ Inseln herstellen, die die wirksame Struktur des Hallelementes 12 definieren. Das Hallelement 12 zeichnet sich deshalb bei sorgfältiger Wahl der Geometrie und des Herstellungsprozesses durch geringe Offsetspannungen aus.

Bei einer Weiterentwicklung des Magnetfeldsensors 1 zur Messung besonders kleiner Magnetfelder B sind das Hallelement 12 und eventuell benachbarte Flächen des Chips mit strukturierten Flächenteilen 17, 18 aus ferromagnetischem Material, wie beispielsweise Permalloy oder Mumetall, beschichtet. Diese Flächenteile 17, 18 stellen Flusskonzentratoren dar, wobei technologiebedingt die Geometrie des Luftspaltes 5 wie auch die Lage des Luftspaltes 5 bezüglich des Hallelementes 12 sehr genau, d.h. mikrometergenau, festlegbar ist. Die Flächenteile 17, 18 weisen eine Dicke von einigen Zehntel bis zu einigen zehn Mikrometern auf und sind beispielsweise durch Sputtern, Aufdampfen und/oder galvanisch aufgebracht worden. Die Flächenteile 17, 18 sind entweder mit den Flusskonzentratoren 3, 4 kombinierbar oder sie können alleinstehende Flusskonzentratoren darstellen.

Bei einer in der Figur 4b dargestellten Variante ist die Aussenelektrode 13 in zwei Elektroden 13a und 13b aufgeteilt, die vorzugsweise u-förmig sind und deren seitliche Arme sich bis etwa auf die Höhe der Sensorelektroden 14 bzw. 16 erstrecken. Die Elektroden 13a und 13b sind elektrisch kurzgeschlossen, so dass sie einen einzigen elektrischen Kontakt des Hallelementes 12 bilden. Die Elektroden 13a, 14, 15, 16 und 13b sind entlang einer fiktiven Geraden 60 angeordnet, die sich entlang des Luftspaltes 5 und senkrecht zu den Feldlinien 6 (Figur 1) des Magnetfeldes innerhalb des Luftspaltes 5 erstreckt.

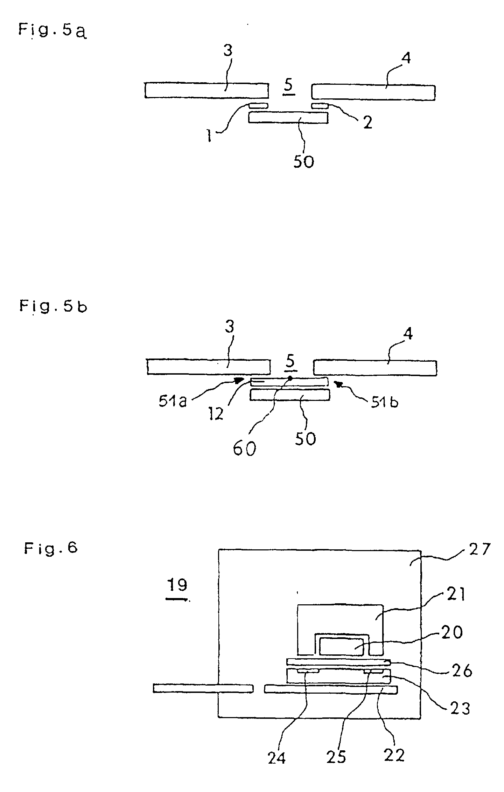

Bei den bisher beschriebenen Magnetfeldsensoren ist das Streufeld symmetrisch bezüglich der y-Achse. Mit einem weiteren magnetischen Körper 50, der wie in den Figuren 5a und 5b gezeigt, unterhalb der Hallelemente 1, 2 (Figur 5a) bzw. des Hallelementes 12 (Figur 5b) und symmetrisch zum Luftspalt angebracht ist, kann der die Hallelemente 1, 2 bzw. das Hallelement 12 durchflutende Streufeldanteil im Vergleich zu dem direkt durch den Luftspalt 5 fliessenden Feldanteil und damit die Empfindlichkeit des Magnetfeldsensors erhöht werden. Die zwischen den Flusskonzentratoren 3, 4 und dem Körper 50 gebildeten Luftspalte 51a, 51b sind kleiner als der Luftspalt 5, so dass das die Hallelemente 1, 2 bzw. das Hallelement 12 durchflutende Magnetfeld im Vergleich zu dem den Luftspalt 5 durchflutenden Magnetfeld möglichst gross ist. Falls die beiden Hallelemente 1, 2 (Figur 1) auf einem einzigen Chip enthalten sind oder falls das Hallelement 12 eingesetzt ist, ist bevorzugt die Rückseite des Chips bzw. des Hallelementes 12 mit ferromagnetischem Material beschichtet, das die Funktion des Körpers 50 übernimmt.

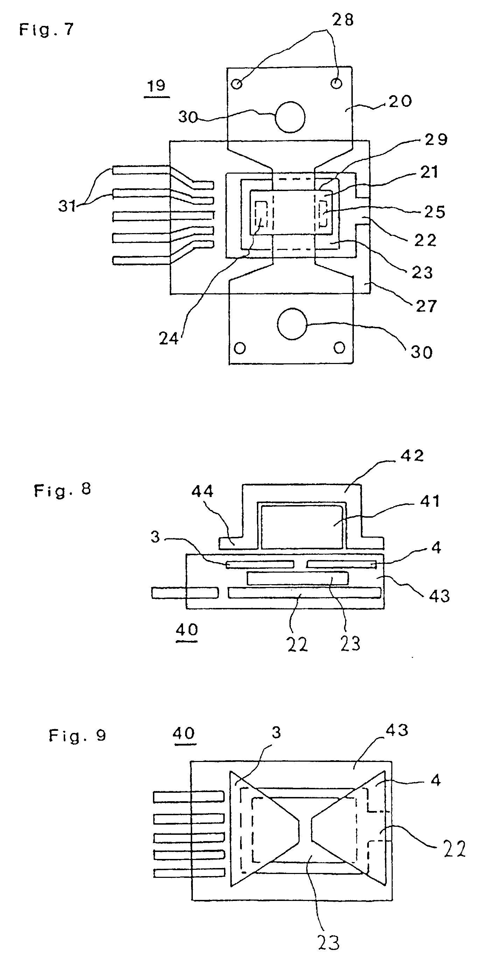

Die Figuren 6 und 7 zeigen in der Draufsicht und im Querschnitt einen Stromsensor 19, der zur Messung vergleichsweise kleiner Ströme von bis zu typisch 20 A geeignet ist. Der Stromsensor 19 umfasst einen Stromleiter 20, ein ferromagnetisches Joch 21, ein Leadframe 22, einen elektronischen Chip 23 mit zwei horizontalen Hallelementen 24, 25, eine Isolationsschicht 26 und ein Kunststoffgehäuse 27. Der Stromleiter 20 ist mit Führungslöchem 28 für eine selbstjustierende Fertigung versehen. Zur Erhöhung der magnetischen Feldstärke ist der Stromleiter 20 im Bereich der Hallelemente 24, 25 mit einer Verjüngung 29 ausgebildet. Der Stromleiter 20 weist ferner ausserhalb des Gehäuses 27 zwei Löcher 30 auf, die mit Anschlussklemmen für einen elektrischen Leiter versehbar sind, dessen Strom mit dem Stromsensor 19 zu messen ist. Das Leadframe ist mit Anschlussbeinen 31 ausgebildet, die der elektrischen Kontaktierung des Chips 23 dienen. Das Joch 21 umschliesst den Stromleiter 20 auf drei Seiten. Auf der vierten Seite des Stromleiters 20 befinden sich die Isolationsschicht 26 und der Chip 23. Die Hallelemente 24, 25 sind auf dem Chip 23 entsprechend den Dimensionen des Stromleiters 20 und des Jochs 21 so plaziert, dass sie sich im Bereich maximaler Stärke des Magnetfeldes B befinden, das von einem den Stromleiter 20 durchfliessenden Strom l erzeugt wird. Der Stromsensor 19 ist in herkömmlicher IC Technologie herstellbar. Er weist die Form eines integrierten Bausteins mit einem Plastikgehäuse auf, wobei neben den wie gewöhnliche Pins aussehenden Anschlussbeinen 31 zwei aus dem Plastikgehäuse 27 herausragende Partien des Stromleiters 20 zum direkten Anschluss von Leitungsdrähten vorhanden sind.

Die Dicke des Stromleiters 20 beträgt typisch einige Zehntel Millimeter oder einen ganzen Millimeter. Im verjüngten Teil 29 entsteht im Betrieb des Stromsensors 19 Wärme, die über den unverjüngten Teil nach aussen und an die Umgebung abzuführen ist, so dass sich der Stromsensor 19 nicht über eine ihn zerstörende Temperatur erwärmt. Der Stromleiter 20 kann ebenfalls als Leadframe ausgebildet sein, so dass der Stromsensor 19 mit der aus der Herstellung von Leistungstransistoren bekannten 2-Leadframe Technologie herstellbar ist. Weiter können über dem Gehäuse 27 mit dem Stromleiter 20 verbundene Kühlkörper vorgesehen sein, damit der verjüngte Teil 29 sehr schmal gehalten werden und die beim maximal zulässigen Strom im Stromleiter 20 erzeugte Wärme dennoch abgeführt werden kann, ohne dass der Stromsensor 19 beschädigt wird.

Das Joch 21 besteht mit Vorteil aus einer Nickel-Eisen Legierung, z.B. aus Mumetall oder Permalloy. Der Stromleiter 20 besteht vorzugsweise aus Kupfer.

Der Stromsensor 19 ist unempfindlich gegen äussere magnetische Störfelder, da das erste Hallelement 24 und das zweite Hallelement 25 ein solches Störfeld mit umgekehrtem Vorzeichen erfassen, da sie je eine positive Hallspannung liefern, wenn die sie durchflutenden magnetischen Felder eine unterschiedliche Richtung aufweisen. Dank dieser Unempfindlichkeit gegen Störfelder eignet sich ein solcher Stromsensor 19 insbesondere zur Messung kleinster Ströme.

Bei einer anderen Ausgestaltung des Stromsensors 19 ist das Joch 21 weggelassen und die beiden Hallelemente 24 und 25 sind ersetzt durch ein einziges Hallelement wie das in der Figur 5b dargestellte. Das Hallelement kann dabei mit den Flusskonzentratoren versehen sein oder auch nicht. Die Abmessungen des Stromleiters 19 sind auf die Geometrie des Hallelementes und gegebenenfalls der Flusskonzentratoren abgestimmt.

Die Figuren 8 und 9 zeigen in der Draufsicht und im Querschnitt einen zur Messung grosser Ströme ausgelegten Stromsensor 40. Der Stromsensor 40 besteht aus drei getrennt herstellbaren Teilen: einem Stromleiter 41, einem ferromagnetischen Joch 42 und einem Magnetfeldsensor 43. Der Magnetfeldsensor 43 ist von der Art des z.B. in der Figur 1 dargestellten Magnetfeldsensors 1. Er weist die Form eines IC Bausteins auf, in den neben den Hallelementen 1, 2 (Figur 2) bzw. dem Hallelement 12 (Figur 4a, Figur 4b) auch die Flusskonzentratoren 3, 4 integriert sind. Das Joch 42 umschliesst den rechteckförmigen Stromleiter 41 auf drei Seiten, während die vierte Seite vom Magnetfeldsensor 43 bedeckt ist. Das Joch 42 ist bevorzugt mit seitlich sich erstreckenden Füssen 44 ausgebildet und mit dem Magnetfeldsensor 43 verklebt. Das Joch 42 und die im Magnetfeldsensor 43 vorhandenen Flusskonzentratoren 3, 4 sind aufeinander abgestimmt, da sie einen magnetischen Kreis bilden, der das vom im Leiter 41 fliessenden Strom erzeugte Magnetfeld führt. Insbesondere sind die beiden Luftspalte zwischen dem Joch 42 und den Flusskonzentratoren 3 bzw. 4 möglichst klein bemessen.

Die Stromsensoren 19 und 40 können bei gleichem geometrischen Aufbau und entsprechender elektrischer Adaptierung auch als Energiesensoren ausgebildet werden.

## Patentansprüche

1. Magnetfeldsensor, der zwei Flusskonzentratoren (3, 4) und einen Sensor zur Messung eines Magnetfeldes aufweist, wobei die Flusskonzentratoren (3, 4) durch einen Luftspalt (5) getrennt sind, **dadurch gekennzeichnet, dass** als Sensor zwei Hallelemente (1, 2) dienen, dass die Hallelemente (1, 2) ausserhalb des Luftspaltes (5) und auf entgegengesetzten Seiten des Luftspaltes (5) in einer parallel zur Ebene der Flusskonzentratoren (3, 4) verlaufenden Ebene angeordnet sind und dass die Hallelemente (1, 2) von Feldlinien (7) des Magnetfeldes durchflutet sind, die vom ersten Flusskonzentrator (3) in der Nähe des Luftspaltes (5) weggehen und in der Nähe des Luftspaltes (5) auf den zweiten Flusskonzentrator (4) auftreffen.

2. Magnetfeldsensor nach Anspruch 1, **dadurch gekennzeichnet, dass** in einer parallel zur Ebene der Flusskonzentratoren (3, 4) verlaufenden Ebene ein Körper (50) aus einem magnetischen Material so angeordnet ist, dass zwischen dem ersten Flusskonzentrator (3) und dem Körper (50) und dass zwischen dem zweiten Flusskonzentrator (4) und dem Körper (50) je ein Luftspalt (51a; 51b) gebildet ist, dass diese Luftspalte (51a; 51b) kleiner als der direkte Luftspalt (5) zwischen den Ftusskonzentratoren (3, 4) sind und dass das erste Hallelement (1) und das zweite Hallelement (2) in diesen Luftspalten (51a; 51b) angeordnet sind.

3. Magnetfeldsensor, der zwei Flusskonzentratoren (3, 4) und ein Hallelement (12) zur Messung eines Magnetfeldes aufweist, wobei die Flusskonzentratoren (3, 4) durch einen Luftspalt (5) getrennt sind, **dadurch gekennzeichnet, dass** das Hallelement (12) ausserhalb des Luftspaltes (5) angeordnet ist und dass ein Teil der vom ersten Flusskonzentrator (3) zum zweiten Flusskonzentrator (4) führenden Feldlinien (7) des Magnetfeldes das Hallelement (12) in annähernd entgegengesetzten Richtungen durchflutet.

4. Magnetfeldsensor nach Anspruch 3, **dadurch gekennzeichnet, dass** die Strom- und Spannungselektroden (13, 14, 15, 16; 13a, 14, 15,16, 13b) des Hallelementes (12) entlang einer fiktiven Geraden (60) angeordnet sind, wobei sich diese Gerade (60) annähernd senkrecht zu den innerhalb des Luftspaltes (5) verlaufenden Feldlinien (6) des Magnetfeldes erstreckt.

5. Strom- oder Energiesensor (19) mit einem Magnetfeldsensor nach einem der Ansprüche 1 bis 4, **dadurch gekennzeichnet, dass** der Strom- bzw. Energiesensor (19) einen Stromleiter (20) mit einer Verjüngung (29) aufweist, dass ein magnetisches Joch (21) den Stromleiter (20) auf drei Seiten umschliesst, dass auf der vierten Seite des Stromleiters (20) der Magnetfeldsensor angeordnet ist und dass Teile des Stromleiters (20), das Joch (21) und der Magnetfeldsensor in ein Kunststoffgehäuse (27) vergossen sind.

6. Strom- oder Energiesensor (19) mit einem Magnetfeldsensor nach einem der Ansprüche 1 bis 4, **dadurch gekennzeichnet, dass** der Strom- bzw. Energiesensor (19) einen Stromleiter (20) mit einer Verjüngung (29) aufweist, dass auf der einen Seite des Stromleiters (20) der Magnetfeldsensor angeordnet ist und dass Teile des Stromleiters (20) und der Magnetfeldsensor in ein Kunststoffgehäuse (27) vergossen sind.

7. Strom- oder Energiesensor (40) mit einem Magnetfeldsensor nach einem der Ansprüche 1 bis 4, **dadurch gekennzeichnet, dass** der Magnetfeldsensor in einem Kunststoffgehäuse (43) vergossen ist, dass das Kunststoffgehäuse (43) und ein magnetisches Joch (42) einen Stromleiter (41) zusammen vollständig umschliessen und dass das Joch (42) und die Flusskonzentratoren (3, 4) des Magnetfeldsensors einen magnetischen Kreis zur Führung des Magnetfeldes bilden, das von dem im Stromleiter (41) fliessenden Strom erzeugt wird.

## Claims

1. A magnetic field sensor which has two flux concentrators (3, 4) and a sensor for measuring a magnetic field, wherein the flux concentrators (3, 4) are separated by an air gap (5), **characterised in that** two Hall elements (1, 2) serve as the sensor, that the Hall elements (1,2) are arranged outside the air gap (5) and on opposite sides of the air gap (5) in a plane running parallel to the plane of the flux concentrators (3, 4) and that field lines (7) of the magnetic field which issue from the first flux concentrator (3) in the vicinity of the air gap (5) and impinge on the second flux concentrator (4) in the vicinity of the air gap (5) pass through the Hall elements (1, 2).

2. A magnetic field sensor according to claim 1, **characterised in that** a body (50) comprising a magnetic material is arranged in a plane running parallel to the plane of the flux concentrators (3, 4) so that a respective air gap (51a; 51b) is formed between the first flux concentrator (3) and the body (50) and between the second flux concentrator (4) and the body (50), that said air gaps (51a; 51b) are smaller than the direct air gap (5) between the flux concentrators (3, 4) and that the first Hall element (1) and the second Hall element (2) are arranged in said air gaps (51a; 51b).

3. A magnetic field sensor which has two flux concentrators (3, 4) and a Hall element (12) for measuring a magnetic field, wherein the flux concentrators (3, 4) are separated by an air gap (5), **characterised in that** the Hall element (12) is arranged outside the air gap (5) and that a part of the field lines (7) of the magnetic field, which lead from the first flux concentrator (3) to the second flux concentrator (4), passes through the Hall element (12) in approximately opposite directions.

4. A magnetic field sensor according to claim 3, **characterised in that** the current and voltage electrodes (13, 14, 15, 16; 13a, 14, 15, 16, 13b) of the Hall element (12) are arranged along a notional straight line (60), said straight line (60) extending approximately perpendicularly to the field lines (6) of the magnetic field running within the air gap (5).

5. A current or energy sensor (19) having a magnetic field sensor according to one of claims 1 to 4, **characterised in that** the current or energy sensor (19) has a current conductor (20) with a reduced portion (29), that a magnetic yoke (21) encloses the current conductor (20) on three sides, that the magnetic field sensor is arranged on the fourth side of the current conductor (20) and that parts of the current conductor (20), the yoke (21) and the magnetic field sensor are cast into a plastics housing (27).

6. A current or energy sensor (19) having a magnetic field sensor according to one of claims 1 to 4, **characterised in that** the current or energy sensor (19) has a current conductor (20) with a reduced portion (29), that the magnetic field sensor is arranged on one side of the current conductor (20) and that parts of the current conductor (20) and the magnetic field sensor are cast into a plastics housing (27).

7. A current or energy sensor (40) having a magnetic field sensor according to one of claims 1 to 4, **characterised in that** the magnetic field sensor is cast in a plastics housing (43), that the plastics housing (43) and a magnetic yoke (42) completely enclose a current conductor (41) and that the yoke (42) and the flux concentrators (3, 4) of the magnetic field sensor form a magnetic circuit for carrying the magnetic field generated by the current flowing in the conductor (41).

## Revendications

1. Capteur de champ magnétique possédant deux concentrateurs de flux (3, 4) et un capteur pour la mesure d'un champ magnétique, dans lequel les concentrateurs de flux (3, 4) sont séparés par un entrefer (5), **caractérisé en ce que** le capteur est formé de deux éléments à effet Hall (1, 2), **en ce que** les éléments à effet Hall (1, 2) sont disposés en dehors de l'entrefer (5) et sur des côtés opposés de l'entrefer (5) dans un plan parallèle aux concentrateurs de flux (3, 4), et **en ce que** les éléments à effet Hall (1, 2) sont parcourus par des lignes de champ (7) du champ magnétique émanant du premier concentrateur de flux (3) à proximité de l'entrefer (5) et atteignant le deuxième concentrateur de flux (4) à proximité de l'entrefer (5).

2. Capteur de champ magnétique selon la revendication 1, **caractérisé en ce qu**'un élément (50) fait d'un matériau magnétique et disposé dans un plan parallèle au plan des concentrateurs de flux (3, 4), de telle manière que des entrefers (51a, 51b) soient créés entre le premier concentrateur de flux (3) et l'élément (50) et entre le second concentrateur de flux (4) et l'élément (50), en ce que ces entrefers (51a, 51b) sont plus petit que l'entrefer (5) direct entre les concentrateurs de flux (3, 4) et en ce que le premier élément à effet Hall (1) et le second élément à effet Hall (2) sont disposés dans ces entrefers (51a, 51b).

3. Capteur de champ magnétique possédant deux concentrateurs de flux (3, 4) et un élément à effet Hall (12) pour la mesure d'un champ magnétique, dans lequel les concentrateurs de flux (3, 4) sont séparés par un entrefer (5), **caractérisé en ce que** l'élément à effet Hall (12) est disposé en dehors de l'entrefer (5) et **en ce qu'**une partie des lignes de champ (7) du champ magnétique allant du premier concentrateur de flux (3) au second concentrateur de flux (4) parcourt l'élément à effet Hall (12) dans des sens approximativement opposés.

4. Capteur de champ magnétique selon la revendication 3, **caractérisé en ce que** les électrodes d'intensité et de tension (13, 14, 15, 16; 13a, 14, 15, 16, 13b) de l'élément à effet Hall (12) sont disposées le long d'une droite fictive (60) approximativement perpendiculaire aux lignes de champ (6) du champ magnétique passant à l'intérieur de l'entrefer (5).

5. Capteur de courant électrique ou d'énergie (19) comportant un capteur de champ magnétique selon l'une quelconque des revendications 1 à 4, **caractérisé en ce que** le capteur de courant électrique ou d'énergie (19) possède un conducteur (20) avec une partie plus étroite (29), **en ce qu'**une culasse magnétique (21) entoure le conducteur (20) sur trois côtés, **en ce que** le capteur de champ magnétique est disposé sur le quatrième côté du conducteur (20) et **en ce que** des parties du conducteur (20), la culasse (21) et le capteur de champ magnétique sont moulés dans un boîtier en plastique (27).

6. Capteur de courant électrique ou d'énergie (19) comprenant un capteur de champ magnétique selon l'une quelconque des revendications 1 à 4, **caractérisé en ce que** le capteur de courant électrique ou d'énergie (19), **en ce que** le capteur de champ magnétique est disposé sur un côté du conducteur (20) et **en ce que** des parties du conducteur (20) et le capteur de champ magnétique sont moulés dans un boîtier en plastique (27).

7. Capteur de courant électrique ou d'énergie (40) comportant un capteur de champ magnétique selon l'une quelconque des revendications 1 à 4, **caractérisé en ce que** le capteur de champ magnétique est moulé dans un boîtier en plastique (43), **en ce que** le boîtier en plastique (43) et une culasse magnétique (42) entourent ensemble complètement un conducteur (41) et **en ce que** la culasse (42) et les concentrateurs de flux (3, 4) du capteur de champ magnétique forment un circuit magnétique pour le passage du champ magnétique généré par le courant qui circule dans le conducteur (41).
